# EUROPEAN PATENT APPLICATION

(11) **EP 2 154 205 A1**
(43) Date of publication of application: **17.02.2010**
(21) Application number: 08764553.7
(22) Date of filing: 23.05.2008
(51) Int. Cl.: C08L 101/00, C08J 5/18, C08K 3/00, G03F 7/004, G03F 7/027, G03F 7/032, G03F 7/038, H01L 23/02

(54) **RESIN COMPOSITION, RESIN SPACER FILM, AND SEMICONDUCTOR DEVICE**

(30) Priority: 25.05.2007 JP 2007139098; 04.06.2007 JP 2007148177
(71) Applicant: Sumitomo Bakelite Company Limited, Shinagawa-ku Tokyo 140-0002 (JP)
(72) Inventor: TAKAHASHI, Toyosei, Tokyo 140-0002 (JP); TAKAYAMA, Rie, Tokyo 140-0002 (JP)
(74) Representative: Solf, Alexander
(86) International application number: PCT/JP2008/059507
(87) International publication number: WO 2008/146723

(57) **Abstract**

The present invention provides a resin composition. The resin composition is used for a resin spacer provided in a semiconductor device. The semiconductor device comprises of a substrate, a semiconductor element mounted on an interposer so as to face the substrate, and the resin spacer provided between the substrate and the interposer or the semiconductor element for bonding them together in a state that a space is formed between the substrate and the semiconductor element. The resin composition comprises an alkali solubility resin, a photopolimerization resin, and a particulate filler. An average particle size of the particulate filler is in the range of 0.05 to 0.35 µm. An amount of the particulate filler contained in the resin composition is in the range of 1 to 40 wt%. Further, the present invention also provides a resin spacer film. The resin spacer film is constituted of the resin composition described above.

## Description

### TECHNICAL FIELD

The present invention relates to a resin composition, a resin spacer film, and a semiconductor device, and more specifically relates to a resin composition, a resin spacer film formed of the resin composition, and a semiconductor device provided with the resin spacer film.

### BACKGROUND ART

There is known a semiconductor device having a semiconductor wafer on which one or more semiconductor elements are mounted and a transparent substrate provided on the semiconductor wafer through a space therebetween. For forming such a space between the semiconductor wafer and the transparent substrate, a photosensitive film is used. The photosensitive film is bonded to the wafer and then the photosensitive film is exposed and developed to form a pattern on the wafer, wherein the remaining portion of the photosensitive film is used or served as the spacer and then a transparent substrate such as a glass substrate is pressure-bonded onto the spacer to produce the semiconductor device. Recently, needs of such a photosensitive film are increased (See, for example, Patent Document 1: Japanese Patent Application Laid-open No. 2006-323089).

It is required for such a photosensitive film formed of a resin composition to have a property that can be subjected to a patterning process by a photolithographic method. In addition to that, it is also required for such a photosensitive film formed of the resin composition to have a property that can exhibit a shape-keeping property as the spacer.
Further, as described above, the resin composition used for forming the spacer is exposed, and then the exposed resin composition is developed. Therefore, it is also required for the resin composition (photosensitive film) to have an excellent developing property.

### DISCLOSURE OF THE INVENTION

It is therefore an object of the present invention to provide a resin composition to be suitably used for forming a spacer used in such a semiconductor device as described above.
It is another object of the present invention to provide a resin spacer film formed of the resin composition, the resin spacer film having an excellent shape-keeping property as the spacer as well as an excellent developing property.
Further, it is other object of the present invention to provide a semiconductor device which includes an interposer on which a semiconductor element is mounted and a substrate bonded to the interposer or semiconductor element through a resin spacer constituted of a cured material of the resin composition described above.

In order to achieve the objects described above, the present inventions are directed to the following features (1) to (6).
(1) A resin composition to be used for a resin spacer formed in a semiconductor device is provided. The semiconductor device comprises a substrate, a semiconductor element mounted on an interposer so as to face the substrate, and the resin spacer provided between the substrate and the interposer or the semiconductor element for bonding them together in a state that a space is formed between the substrate and the semiconductor element. The resin composition comprises: an alkali solubility resin; a photopolimerization resin; and a particulate filler. An average particle size of the particulate filler is in the range of 0.05 to 0.35 µm, and an amount of the particulate filler contained in the resin composition is in the range of 1 to 40 wt%.
(2) In the resin composition described in the above-mentioned item (1), the particulate filler includes silica.
(3) In the resin composition described in the above-mentioned item (1), the resin composition further comprises a thermosetting resin being different from the alkali solubility resin.
(4) A resin spacer film is constituted of the resin composition defined in the above-mentioned item (1).
(5) In the resin spacer film described in the above-mentioned item (4), the resin spacer film has an elastic modulus, and when the elastic modulus is measured under the following conditions, the elastic modulus of the resin spacer film is 500 Pa or more: (1) a thickness of the resin spacer film is 100 µm; (2) the resin spacer film which an ultraviolet ray of 700 (mJ/cm²) has exposed is used; and (3) a measurement temperature is 130°C.
(6) A semiconductor device comprises: a substrate having one surface; an interposer having one surface facing the one surface of the substrate; a semiconductor element mounted on the one surface of the interposer; and a resin spacer provided between the substrate and the interposer or the semiconductor element for bonding them together in a state that a space is formed between the substrate and the semiconductor element. The resin spacer is formed by curing the resin composition defined in the above-mentioned item (1).

### BRIEF DESCRIPTION OF THE DRAWINGS

FIG. 1 is a cross-section view showing one example of a semiconductor device.
FIGs. 2A to 2D are cross-section views schematically showing production steps of a semiconductor device.
FIG. 3 is a cross-section view showing one example of another semiconductor device.

### BEST MODE FOR CARRYING OUT THE INVENTION

Hereinbelow, a resin composition, a resin spacer film, and a semiconductor device according to the present invention will be described in detail.
The resin composition according to the present invention is a resin composition to be used for forming a resin spacer which is used to form or provide a space between a substrate and a semiconductor element or interposer. The resin composition contains an alkali solubility resin, a photopolymerization resin, a photopolymerization initiator, and a particulate filler. An average particle size of the filler is in the range of 0.05 to 0.35 µm. An amount of the filler contained in the resin composition is in the range of 1 to 40 wt%.
Further, the resin spacer film according to the present invention is constituted of the resin composition described above.
Furthermore, the semiconductor device according to the present invention has a feature that an interposer on which the semiconductor element is mounted is bonded to the substrate through the resin spacer which is constituted of a cured material of the resin composition described above.

First, a description will be made on the resin composition and the resin spacer film 4'. The resin composition according to the present invention is used for forming a resin spacer 4 as shown in FIG. 1. The resin spacer 4 is used for forming or providing a space 3 between a substrate 1 and an interposer 5 (or a semiconductor element 2) which are included in a semiconductor device 100 as shown in FIG. 1.
As described above, such a resin composition contains the alkali solubility resin, the photopolymerization resin, and the particulate filler. The average particle size of the filler is in the range of 0.05 to 0.35 µm. The amount of the filler contained in the resin composition is in the range of 1 to 40 wt%. This makes it possible for the resin spacer 4 to exhibit excellent shape-keeping property and for the resin composition (resin spacer film 4') to exhibit excellent developing property. In particular, it is possible to reduce residues which are likely to be left on the semiconductor element 2 or the interposer 5 after a development.

The resin composition contains the alkali solubility resin. This makes it possible to develop the resin composition (resin spacer film 4') under the alkali condition. Examples of such an alkali solubility resin include: a novolac resin such as a cresol-type novolac resin, a phenol-type novolac resin, a bisphenol A-type novolac resin, a bisphenol F-type novolac resin, a catechol-type novolac resin, a resorcinol-type novolac resin, and a pyrogallol-type novolac resin; a phenol aralkyl resin; a hydroxystyrene resin; an acryl-based resin such as a methacrylic acid resin and a methacrylate resin; a cyclic olefin-based resin having hydroxyl groups, carboxyl groups, and the like; a polyamide-based resin (concretely, a resin having at least one of a polybenzoxazole structure and a polyimide structure in a chemical structure thereof, and having hydroxyl groups, carboxyl groups, ether groups, or ester groups in a main chain or branch chains of the chemical structure thereof; a resin having a polybenzoxazole precursor structure; a resin having a polyimide precursor structure; a resin having a polyamide acid ester structure; and the like.

Further, it is preferred that such an alkali solubility resin is a resin having alkali solubility groups and double bonds in the chemical structure thereof.
Examples of such a resin having the alkali solubility groups and the double bonds include a curable resin which can be cured by both heat and light.
Examples of the alkali solubility groups include a hydroxyl group, a carboxyl group, and the like. The alkali solubility groups can also contribute to a thermal curing reaction of the resin.
Examples of such a resin (curable resin) include: a thermosetting resin having light reaction groups such as an acryloyl group, a methacryloyl group, and a vinyl group; a light curing resin having thermal reaction groups such as a phenolic hydroxyl group, an alcoholic hydroxyl group, a carboxyl group, and an anhydride group; and the like. In this regard, it is to be noted that the light curing resin may further have the thermal reaction groups such as an epoxy group, an amino group, a cyanate group, and the like. Concretely, examples of the light curing resin include a (meth)acryl-modified phenol resin, an acryl acid polymer containing (meth)acryloyl groups, an (epoxy)acrylate containing carboxyl groups, and the like. Further, the light curing resin may be a thermoplastic resin such as an acryl resin containing carboxyl groups.
Among these resins, the (meth)acryl-modified phenol resin is preferable. By using the resin having the alkali solubility groups, when the resin in which the double bonds have not reacted is removed from the exposed resin during the developing treatment, an alkali solution can be used as a liquid developer instead of an organic solvent which is normally used. Such an alkali solution has less adverse effect on environment than the organic solvent. Further, since the double bonds included in the resin contribute to a curing reaction, it is possible to maintain heat resistance of the resin composition.

In a case where the thermosetting resin having the light reaction groups is used as the alkali solubility resin, a modified rate (substitutional rate) of the light reaction groups is not particularly limited to a specific value. The modified rate of the light reaction groups is preferably in the range of 20 to 80%, and more preferably 30 to 70% with respect to total reaction groups of the resin having the alkali solubility groups and the double bonds (namely, the thermosetting resin). If the modified rate of the light reaction groups falls within the above noted range, it is possible to provide a resin composition having excellent resolution.

On the other hand, in a case where the light curing resin having the thermal reaction groups is used as the alkali solubility resin, a modified rate (substitutional rate) of the thermal reaction groups is not particularly limited to a specific value. The modified rate of the thermal reaction groups is preferably in the range of 20 to 80%, and more preferably in the range of 30 to 70% with respect to total reaction groups of the resin having the alkali solubility groups and the double bonds (namely, the light curing resin). If the modified rate of the thermal reaction groups falls within the above noted range, it is possible to provide a resin composition having excellent resolution.

A weight-average molecular weight of the resin having the alkali solubility groups and the double bonds is not particularly limited to a specific value, but preferably 30,000 or less, and more preferably in the range of 5,000 to 15,000. If the weight-average molecular weight of the resin falls within the above noted range, it is possible to exhibit excellent film formation property in a case where the resin composition is used to the resin spacer film 4'.
The weight-average molecular weight can be obtained by using a gel permeation chromatographic apparatus (GPC). That is, the gel permeation chromatographic apparatus can calculate the weight-average molecular weight by using a calibration curve. The calibration curve is preliminarily made by using styrene standard substances having different weight-average molecular weights with the gel permeation chromatographic apparatus. In this regard, it is to be noted that the measurement using the gel permeation chromatographic apparatus is carried out under the conditions that tetrahydrofuran (THF) is used as a measurement solvent and a measurement temperature is 40°C.

An amount of the alkali solubility resin contained in the resin composition is not particularly limited to a specific value, but preferably in the range of 15 to 50 wt%, and more preferably in the range of 20 to 40 wt% with respect to a total amount of the resin composition. Particularly, the amount of the alkali solubility resin is more preferably in the range of 10 to 80 wt%, and even more preferably in the range of 15 to 70 wt% with respect to total resin components (total components except for the filler contained in the resin composition) contained in the resin composition.

The resin composition contains the photopolymerization resin. This makes it possible to improve the patterning property of the resin composition with the alkali solubility resin.
Examples of the photopolymerization resin include: an unsaturated polyester; an acryl-based compound such as an acryl-based monomer and an acryl-based oligomer having at least one or more of an acryloyl group, or a methacryloyl group in a chemical structure thereof; a vinyl-based compound such as styrene; and the like. These resins may be used singly or in combination of two or more of them.

Among these resins, the acryl-based compound is preferable as the photopolymerization resin, and an ultraviolet curable resin mainly constituted of the acryl-based compound is preferable. This is because a curing rate of the acryl-based compound is fast when the acryl-based compound is exposed to light, and therefore it is possible to form a pattern to the resin spacer film 4' constituted of the resin composition with a relative small exposure amount.

Examples of the acryl-based compound include: an acrylic acid ester or a metacrylic acid ester as a monomer; and the like. Concretely, examples of the acryl-based compound include: a difunctional acrylate such as diacrylic acid ethylene glycol, dimethacrylic acid ethylene glycol, diacrylic acid 1,6-hexanediol, dimethacrylic acid 1,6-hexanediol, diacrylic acid glycerin, dimethacrylic acid glycerin, diacrylic acid 1,10-decanediol, and dimethacrylic acid 1,10-decanediol; a polyfunctional acrylate such as triacrylic acid trimethylol propane, trimethacrylic acid trimethylol propane, triacrylic acid pentaerythritol, trimethacrylic acid pentaerythritol, hexacrylic acid dipentaerythritol, hexamethacrylic acid dipentaerythritol; and the like.
Among these compounds, the metacrylic acid ester is preferable. In particular, the acrylic acid ester or an acrylic acid alkyl ester in which a carbon number of ester parts is in the range of 1 to 15 is more preferable. This makes it possible to improve reactivity of the acryl-based compound (photopolymerization resin), thereby improving sensitivity to the light.

A form of the photopolymerization resin is not particularly limited to a specific form, but preferably a liquid form at room temperature. This makes it possible to improve curing reactivity of the photopolymerization resin by an ultraviolet ray. Further, it is possible to easily mix the photopolymerization resin with the other components (e.g. alkali solubility resin) contained in the resin composition. Examples of the photopolymerization resin in the liquid form at the room temperature include: the ultraviolet curable resin mainly constituted of the acryl-based compound described above; and the like.

A weight-average molecular weight of the photopolymerization resin is not particularly limited to a specific value, but preferably 5,000 or less, and more preferably in the range of 150 to 3,000. If the weight-average molecular weight of the photopolymerization resin falls within the above noted range, the resin spacer film 4' constituted of the resin composition exhibits excellent sensitivity to the light of curing. In addition to that, the resin spacer film 4' exhibits excellent resolution.
The weight-average molecular weight can be obtained by using the gel permeation chromatographic apparatus (GPC). That is, the gel permeation chromatographic apparatus can calculate the weight-average molecular weight by using a calibration curve. The calibration curve is preliminarily made by using styrene standard substances having different weight-average molecular weights with the gel permeation chromatographic apparatus. In this regard, it is to be noted that the measurement using the gel permeation chromatographic apparatus is carried out under the conditions that tetrahydrofuran (THF) is used as a measurement solvent and a measurement temperature is 40°C.

An amount of the photopolymerization resin contained in the resin composition is not particularly limited to a specific value, but preferably in the range of 5 to 60 wt%, and more preferably in the range of 8 to 30 wt% with respect to the total amount of the resin composition. Particularly, the amount of the photopolymerization resin is more preferably 9 wt% or more, and even more preferably 13 wt% or more with respect to the total resin components (total components except for the filler contained in the resin composition) contained in the resin composition.
If the amount of the photopolymerization resin contained in the resin composition exceeds the upper limit value noted above, there is a case that heat resistance of the resin composition is reduced. If the amount of the photopolymerization resin contained in the resin composition is smaller than the lower limit value noted above, there is a case that flexibility of a resin spacer 4 (resin spacer film 4') produced by using the resin composition is reduced. Further, there is also a case that it is difficult to reliably carry out a patterning process of the resin spacer film 4' constituted of the resin composition by being exposed to light (e.g. ultraviolet ray). Therefore, the amount of the photopolymerization resin contained in the resin composition falls within above noted range, it is possible to obtain an excellent balance among the heat resistance of the resin composition, the flexibility of the resin spacer 4, and the patterning property of the resin spacer film 4' constituted of the resin composition. That is to say, it is possible not to fail to maintain the balance between the heat resistance of the resin composition and the flexibility of the resin spacer 4. Therefore, it is possible to provide the resin composition to be used for a bonding film having good peeling property to a protect film when the resin composition is used for the bonding film.

The resin composition contains the particulate filler. The average particle size of the filler is in the range of 0.05 to 0.35 µm. The amount of the filler contained in the resin composition is in the range of 1 to 40 wt%. This makes it possible to reduce residues which are likely to be left on the interposer 5 (or semiconductor element 2) after the developing treatment. Further, it is possible to obtain excellent shape-keeping property of the resin spacer film 4' in a case where the resin composition is used for the resin spacer film 4'. In addition, it is possible to obtain an excellent balance between the developing property and the shape-keeping property of the resin spacer film 4'.
Examples of such a particulate filler include: an organic filler such as fine particles constituted of a phenol resin, an acryl resin, polyamide, polyslufone, polystyrene, and a fluororesin; an inorganic filler as described later; and the like. Among these fillers, the inorganic filler is preferable. This makes it possible to improve heat resistance, dimensional accuracy, and moisture resistance of the resin spacer 4 which is constituted of the resin composition. It is possible to improve peeling property of a bonding film with respect to a protect film in a case where the resin composition is used as the bonding film.

Examples of such an inorganic filler include: silicate such as talc, sintered clay, non-sintered clay, mica, and glass; silica powder such as fused silica (fused spherical silica and fused-crusted silica), and crystal silica; an oxide such as titanium oxide, alumina, an oxide of silica powder; a carbonate such as calcium carbonate, magnesium carbonate, and hydrotalcite; a hydroxide such as aluminum hydroxide, magnesium hydroxide, and calcium hydroxide; a sulfate or a sulfite such as barium sulfate, calcium sulfate, and calcium sulfite; a borate such as zinc borate, barium metaborate, aluminum borate, calcium borate, and sodium borate; a nitride such as aluminium nitride, boron nitride, and silicon nitride; and the like. These inorganic fillers may be used singly or in combination of two or more of them. Among these fillers, the silica powder such as the fused silica and the crystal silica is preferable, and more preferably the fused spherical silica.

An average particle size of the particulate filler is preferably in the range of 0.05 to 0.35 µm. This makes it possible to reduce residues which are likely to be left on the interposer 5 after the developing treatment. If the average particle size of the particulate filler exceeds the upper limit value noted above, there is a case that the effect of reducing the residues which are likely to be left on the interposer 5 after the developing treatment is reduced. If the average particle size of the particulate filler is smaller than the lower limit value noted above, there is a case that workability for producing the resin composition or the resin spacer 4 is lowered.
The average particle size of the particulate filler is more preferably in the range of 0.1 to 0.3 µm, and even more preferably in the range of 0.1 to 0.25 µm. This makes it possible to reduce the residues which are likely to be left on the interposer 5. In addition to that, it is possible to improve recognition property (visibility) of the resin spacer film 4' in a case where the resin composition is used as the resin spacer film 4'.
The average particle size of the particulate filler is measured by using a particle size distribution measurement apparatus of a laser diffraction type (SALD-7000). The measurement is carried out by using a sample in which the filler is dispersed in water. Before the measurement, an ultrasonic wave is applied to the sample for one minute. Thereafter, the measurement is stated.

An amount of the particulate filler contained in the resin composition is preferably in the range of 1 to 40 wt% with respect to the total amount of the resin composition. This makes it possible to obtain excellent shape-keeping property that a space 3 is kept between the substrate 1 and the semiconductor element 2. If the amount of the particulate filler contained in the resin composition exceeds the upper limit value noted above, there is a case that the effect of reducing the residues which are likely to be left on the interposer 5 after the developing treatment is reduced. If the amount of the particulate filler contained in the resin composition is smaller than the lower limit value noted above, there is a case that the shape-keeping property of the resin spacer 4 is lowered.
The amount of the particulate filler contained in the resin composition is more preferably in the range of 3 to 38 wt%, and even more preferably in the range of 5 to 35 wt% with respect to the total amount of the resin composition.

The resin composition may contain an additional component other than the alkali solubility resin, the photopolymerization resin, and the particulate filler described above. Examples of such an additional component include, but not limited thereto, a thermosetting resin, a curing agent (photosensitizing agent), an ultraviolet absorber, a leveling agent, and the like.
The thermosetting resin has a function of improving heat resistance of the resin spacer film 4'. A resin chemical structure of such a thermosetting resin is different from that of the alkali solubility resin.
Examples of the thermosetting resin include: a novolac-type phenol resin such as a phenol novolac resin, a cresol novolac resin, and a bisphenol A novolac resin; a phenol resin such as a resol phenol resin; a bisphenol-type epoxy resin such as a bisphenol A epoxy resin, and a bisphenol F epoxy resin; a novlolac-type epoxy resin such as a novolac epoxy resin, and cresol novolac epoxy resin; an epoxy resin such as a biphenyl-type epoxy resin, a stilbene-type epoxy resin, a triphenol methane-type epoxy resin, an alkyl modified triphenol methane-type epoxy resin, a triazine chemical structure-containing epoxy resin, and a dicyclopentadiene modified phenol-type epoxy resin; a resin having triazine rings such as an urea resin, and a melamine resin; an unsaturated polyester resin; a bismaleimide resin; a polyurethane resin; a diallyl phthalate resin; a silicone resin; a resin having benzooxazine rings; a cyanate ester resin; and the like. These resins may be used singly or in combination of two or more of them. Among these resins, the epoxy resin is preferable. This makes it possible to improve the heat resistance and adhesion of the resin spacer film 4' which is constituted of the resin composition.

Further, a silicone modified epoxy resin is more preferably used as the epoxy resin. Furthermore, both an epoxy resin in a form of a solid at room temperature (in particular, bisphenol-type epoxy resin) and an epoxy resin in a form of a liquid at room temperature (in particular, silicone modified epoxy resin) are even more preferably used as the epoxy resin. This makes it possible to provide a resin composition to produce a resin spacer film 4' having heat resistance, excellent resolution, and excellent flexibility.

An amount of the thermosetting resin contained in the resin composition is not particularly limited to a specific value, but preferably in the range of 10 to 40 wt%, and more preferably in the range of 15 to 35 wt% with respect to the total amount of the resin composition. If the amount of the thermosetting resin contained in the resin composition is smaller than the lower limit value noted above, there is a case that an effect of improving the heat resistance of the resin spacer film 4' is reduced. If the amount of the thermosetting resin contained in the resin composition exceeds the upper limit value noted above, there is a case that there is a case that an effect of improving toughness of the resin spacer film 4' is reduced.

The curing agent (photosensitizing agent) has a function of being capable of efficiently carrying out the patterning process of the resin spacer film 4' by a photo polymerization.
Such a curing agent (photosensitizing agent) is not particularly limited to a specific material as long as the alkali solubility resin and the photopolymerization resin are cured.
Examples of such a curing agent (photosensitizing agent) include benzophenone, acetophenone, benzoin, benzoin isobutyl ether, benzoin methyl benzoate, benzoin benzoic acid, benzoin methyl ether, benzyl phenyl sulfide, benzyl, dibenzyl, diacetyl, and the like.

An amount of the curing agent (photosensitizing agent) contained in the resin composition is not particularly limited to a specific value, but preferably in the range of 0.5 to 5 wt%, and more preferably in the range of 0.8 to 2.5 wt% with respect to the total amount of the resin composition. If the amount of the curing agent (photosensitizing agent) contained in the resin composition is smaller than the lower limit value noted above, there is a case that an effect of starting the photopolymerization is reduced. If the amount of the curing agent (photosensitizing agent) contained in the resin composition exceeds the upper limit value noted above, reactivity of the photopolymerization is extremely improved, and therefore there is a case that storage stability of the resin composition before use is lowered. Further, there is also a case that resolution of the resin spacer film 4' after carrying out the patterning process described above is lowered. Therefore, if the amount of the curing agent (photosensitizing agent) contained in the resin composition falls within the above noted range, it is possible to provide the resin composition which has an excellent balance between the storage stability thereof and the resolution of the resin spacer film 4'.

The resin composition as described above is mixed into a predetermined organic solvent such as N-metyl-2-pyrrolidone, anisole, methyl ethyl ketone, toluene, and ethyl acetate to a mixture. Then, the mixture is applied to a supporting film and the like, and the applied mixture is dried to thereby obtain a resin spacer film 4'.

A thickness of the resin spacer film 4' is not particularly limited to a specific value as long as it is substantially the same as a thickness of a required resin spacer. The thickness of the resin spacer film 4' is preferably in the range of 20 to 150 µm, and more preferably in the range of 30 to 80 µm. If the thickness of the resin spacer film 4' falls within the above range, it is possible to make a predetermined distance between a light receiving section 21 and the substrate 1 in a case where the resin spacer 4 is used to the semiconductor device 100 having the light receiving section 21. Therefore, since focal point is missed due to the predetermined distance, it is possible to reduce an adverse effect in a case where dust and the like adhere to the substrate 1.

Furthermore, it is preferred that the resin spacer film as described above satisfies the following requirement. When an elastic modulus of the resin spacer film 4' is measured under the following conditions (1) to (3), the elastic modulus is preferably 500 Pa or more, more preferably 1,000 Pa or more, and even more preferably 5,000 Pa or more. If the elastic modulus of the resin spacer film 4' exceeds the lower limit value noted above, it is possible to obtain excellent shape-keeping property of the resin spacer 4. The upper limit value of the elastic modulus noted above is not particularly limited to a specific value, but preferably 200,000 Pa or less, and more preferably 150,000 Pa or less. If the elastic modulus of the resin spacer film 4' exceeds the upper limit value noted above, there is a case that stress to be applied to the resin spacer film 4' is not sufficiently relieved, thereby lowering reliability of the resin spacer film 4'.
(1) The thickness of the resin spacer film 4' is 100 µm.
(2) The resin spacer film 4' exposed to ultraviolet ray of 700 (mJ/cm²) is used.
(3) A measurement temperature is 130°C.
   The elastic modulus is measured by a dynamic viscoelastic measurement apparatus "Rheo Stress RS150" (by manufactured HAAKE Inc.). Concretely, first, a resin layer (which is constituted of the resin composition described above) having a thickness of 50 µm is formed on a polyester film having a size of 250 mm × 200 mm to obtain a laminated body. Then, the laminated body is cut in a size of 30 mm × 30 mm to obtain three first samples. Next, light exposes the resin layer of the each of the three first samples by using a mercury lamp to thereby cure the resin layer. An exposure amount of the light having wavelength of 365 nm is 700 mJ/cm². Next, each of the resin layer is peeled from the polyester film to obtain a second sample. Then, the obtained three second samples are laminated to each other, and then are set in the dynamic viscoelastic measurement apparatus. In the dynamic viscoelastic measurement apparatus, a gap between cone plates to set the sample is adjusted to 100 µm. That is, the laminated three second samples are set to the gap, and then the cone plates are pressed to obtain the gap of 100 µm. The conditions to measure the elastic modulus are set that frequency is 1 Hz, a rate of temperature increase is 10°C/min, a temperature range is in the range of room temperature to 250°C.

It is preferred that the elastic modulus is measured at a temperature of pressure-bonding the substrate 1. Generally, it is preferably in the range of 80 to 180°C. If the elastic modulus measured at a temperature of 130°C which is an intermediate value of the above noted range falls within the above noted range, the resin spacer 4 has excellent shape-keeping property.
The reason why the thickness of the resin spacer film 4' is 100 µm is as follows. Essentially, it is preferred that the elastic modulus of the resin spacer film 4' of which thickness is the same as that of the resin spacer 4 to be used to the semiconductor device 100 is measured. However, in a case where the thickness of the resin spacer 4 is thin, there is a case that the elastic modulus to be measured is obtained ununiformly. Therefore, the thickness of the resin spacer film 4' is set 100 µm, and the elastic modulus of the resin spacer film 4' is measured.
In this regard, it is to be noted that the elastic modulus of the resin spacer (resin spacer film) having an actually thickness is substantially the same as that of the resin spacer film 4' having the thickness of 100 µm.
The reason why the ultraviolet ray of 700 (mJ/cm²) exposes the resin spacer film 4' is that the resin spacer film 4' is sufficiently cured with light. In this regard, in a case where the thickness of the resin spacer film 4' is changed, the exposure amount of the light may be adjusted appropriately.

Next, a description will be made on a semiconductor device and a method of manufacturing the semiconductor device based on preferable embodiments.
First, the resin spacer film 4' described above is bonded on one surface (upper surface in FIG. 2A) of the interposer 5 to which the semiconductor element 2 having the light receiving section 21 is mounted.
Next, in order to form the space 3 to a portion of the resin spacer film 4' to which the semiconductor element 2 is mounted, a mask 6 is provided above a portion other than a portion of the resin spacer film 4' to which the resin spacer 4 is formed. Then, the ultraviolet ray 7 exposes the mask 6 and the resin spacer film 4' as shown in FIG. 2B. As a result, the portion (which becomes the resin spacer 4) of the resin spacer film 4' which the ultraviolet ray 7 has exposed is cured by light (ultraviolet ray).
Next, the mask 6 is removed. Then, the portion of the resin spacer film 4' which the ultraviolet ray 7 has not exposed due to the mask 6 is removed by subjecting to the developing treatment. This makes it possible to form the resin spacer 4 and the space 3 as shown in FIG. 2C.
Next, the semiconductor element 2 having the light receiving section 21 is mounted on the interposer 5 on which the resin spacer film 4' has been removed, which is positioned in the space 3 as shown in FIG. 2D. Thereafter, a functional surface of the semiconductor element 2 is bonded to terminals of the interposer 5 by using bonding wires 22 as shown in FIG. 2D.
Next, the substrate 1 is heated and pressure-bonded to an upper surface (above in FIG. 2D) of the resin spacer 4 to obtain the semiconductor device 100 as shown in FIG. 1. The heating and pressure-bonding process is normally carried out within the range of 80 to 180°C. Therefore, if the elastic modulus of the resin spacer film 4' to be measured at a temperature of 130°C falls within the range described above, it becomes possible to obtain excellent shape-keeping property of the resin spacer 4.
As described above, the semiconductor device 100 according to the present invention is produced by using the resin spacer film 4'. Therefore, when the semiconductor device 100 is produced, it is possible to obtain excellent patterning property. That is, it is possible to easily form the pattern to the resin spacer film 4'. Further, it is also possible to obtain excellent developing property. That is, it is possible to prevent residues which are likely to be left on the interposer 5. Furthermore, it is also possible to obtain excellent shape-keeping property of the resin spacer 4 in heating and pressure-bonding the substrate 1 to the upper surface of the resin spacer 4. In other words, it is possible to obtain both the excellent developing property of the resin spacer film 4' and the excellent shape-keeping property of the resin spacer 4 and the resin spacer film 4'.
Further, the semiconductor device 100 according to the present invention has the space 3 which is formed by the resin spacer 4. Therefore, it is possible to accurately form the resin spacer 4 having an uniform thickness. Further, the semiconductor device 100 according to the present invention has the excellent shape-keeping property of the resin spacer 4. Therefore, it is possible to obtain excellent reliability of the semiconductor device 100.
Further, another embodiment of the semiconductor device according to the present invention may be a semiconductor device 100 as shown in FIG. 3. In the semiconductor device 100 as shown in FIG. 3, a resin spacer 4 which is the same as the resin spacer 4 described above is provided on an outer circumference portion (functional surface of the semiconductor element 2) of the light receiving section 21 provided on a semiconductor element 2. A substrate 1 is heated and pressure-bonded on an upper surface (upper in FIG. 3) of the resin spacer 4. In this way, entirely the semiconductor element 2 is not covered with the substrate 1 and the resin spacer 4, but the semiconductor element 2 is mounted on the interposer 5 so that the light receiving section 21 is covered with the substrate 1 and the resin spacer 4. As shown in FIG. 3, bonding wires 22 are provided on an outer circumference portion of the resin spacer 4 provided on the semiconductor element 2 (functional surface), and are electrically bonded with the terminals of the interposer 5. According to the semiconductor device 100 as shown in FIG. 3, it is possible to downsize the size of the device. Furthermore, the light receiving section 21 is covered with the substrate 1 and the resin spacer 4, thereby forming a space 3 between the substrate 1 and the light receiving section 21 as shown in FIG. 3. This makes it possible to carry out post-steps (processes) at a low clean level of an atmosphere during producing the semiconductor device 100.
Furthermore, the semiconductor device 100 as shown in FIG. 3 makes it possible to lower the thickness of the resin spacer 4, thereby providing better reliability of the semiconductor device 100.

### EXAMPLES

Hereinafter, a description will be made on a number of concrete examples of the present invention, but the present invention is not limited thereto.

### (Example 1)

### 1. Alkali Solubility Resin (Synthesis of Resin Having Alkali Solubility Groups and Double Bonds (Curing Resin Be Curable By Both Light and Heat: (meth)acryl modified bisphenol A novolac resin: MPN))

A bisphenol A novolac resin ("Phenol iteLF-4871", produced by DIC corporation) in a solid form was added into a 2L flask with a MEK solution of 500 g so that an amount of the bisphenol A novolac resin was 60 wt% with respect to the MEK solution of 500 g to obtain a first mixture. Tributylamine of 1.5 g as a catalyst and hydroquinone of 0.15 g as a polymerization inhibitor were added into the first mixture, and then the first mixture was heated at a temperature of 100°C. Glycidyl methacrylate of 180.9 g was further added into the first mixture in drop by drop for 30 minutes to obtain a second mixture. Then, the second mixture was stirred for 5 hours at a temperature of 100°C to obtain a methacryl-modified bisphenol A novolac resin (methacryl modified rate : 50%) with a nonovolatile content of 74%.

### 2. Production of Resin Varnish

A third mixture was prepared so that an amount of the above synthesized methacryl-modified bisphenol A novolac resin (MPN) as the alkali solubility resin (which is curing resin being curable by both light and heat) was 31.74 wt%, an amount of an acryl resin monomer having a liquid form at room temperature as a photopolymerization resin ("NKester 3G", produced by SHIN-NAKAMURA CHEMICAL CO.,LTD) was 9.83 wt%, an amount of a bisphenol A novolac-type epoxy resin as a thermosetting resin ("EpiclonN-865", produced by DIC Corporation) was 19.84 wt%, an amount of a silicone epoxy resin ("BY16-115", produced by Dow Cornng Toray Co., Ltd) was 3.63 wt%, and an amount of silica as a particulate filler ("KE-P30", produced by NIPPON SHOKUBAI Co., Ltd); an average particle size: 0.28 µm; a maximum particle size: 0.9 µm) was 33.71 wt%. Methyl ethyl ketone ("MEK", produced by Daishin-Chemical Co., Ltd) was added into the third mixture so that a concentration of resin components was 71% to obtain a fourth mixture. Thereafter, the fourth mixture was stirred until the bisphenol A novolac-type epoxy resin (N-865) was dissolved.
Next, the silica contained in the fourth mixture was dispersed by using a bead mill (diameter of the beads was 400 µm, a treatment rate was 6 g/s, 5 pass).
A curing agent (photosensitizing agent) ("IRGACURE651", produced by Chiba Specialty Chemicals K.K) was added into the fourth mixture so that an amount thereof was 1.25 wt% to obtain a fifth mixture, and then the fifth mixture was stirred for 1 hour to obtain a resin varnish.

### 3. Production of Resin Spacer Film

The resin varnish described above was applied onto a polyester film (of which thickness was 25 µm), and then the applied resin varnish was dried for 15 minutes at a temperature of 80°C to obtain a resin spacer film. Next, the resin spacer film was exposed with an exposure amount of 700 mJ/cm². Thereafter, an elastic modulus of the exposed resin spacer film was measured at a temperature of 130°C. As a result, the elastic modulus of the exposed resin spacer film at the temperature of 130°C was 500 Pa or more as shown in the following Table 1. As described above, the elastic modulus of the exposed resin spacer film at the temperature of 130°C was measured as follows. Light having 700 mJ/cm² and a wave length of 365 nm exposed three resin spacer films, and then the three resin spacer films were laminated to each other to obtain a laminated body. Next, the laminated body was set to a dynamic viscoelastic measurement apparatus "Rheo Stress RS150" (by manufactured HAAKE Inc.). Then, the measurement of the elastic modulus was carried out under the conditions that frequency was 1 Hz, a gap between cone plates descried above was 100 µm, a temperature range was in the range of room temperature to 200°C, a rate of temperature increase was 10°C/min to obtain an elastic modules of the exposed resin spacer film.

### 4. Manufacture of Semiconductor Device

The resin spacer film was laminated (formed) on a semiconductor wafer (interposer). The resin spacer film was exposed through a mask, and then the exposed resin spacer film was developed to obtain a resin spacer (space). Thereafter, a glass substrate was heated and pressure-bonded on an upper surface of the resin spacer at a temperature of 120°C. Finally, the semiconductor wafer was diced (die-cut) to obtain a semiconductor device.

### (Example 2)

A semiconductor device was manufactured in the same manner as in the Example 1 except that the filler was changed to the following filler: a filler ("NSS-3N", by produced TOKUYAMA Corp.; an average particle size: 0.125 µm; a maximum particle size: 0.35 µm) was used. The resin spacer film was exposed with an exposure amount of 700 mJ/cm². Thereafter, an elastic modulus of the exposed resin spacer film was measured at a temperature of 130°C. As a result, the elastic modulus of the exposed resin spacer film at the temperature of 130°C was 500 Pa or more as shown in the following Table 1.

### (Example 3)

A semiconductor device was manufactured in the same manner as in the Example 1 except that the filler was changed to the following filler: a filler ("SFP-20M", by produced DENKI KAGAKU KOGYO KABUSHIKI KAISHYA; an average particle seize: 0.33 µm; a maximum particle size: 0.8 µm) was used. The resin spacer film was exposed with an exposure amount of 700 mJ/cm². Thereafter, an elastic modulus of the exposed resin spacer film was measured at a temperature of 130°C. As a result, the elastic modulus of the exposed resin spacer film at the temperature of 130°C was 500 Pa or more as shown in the following Table 1.

### (Example 4)

A semiconductor device was manufactured in the same manner as in the Example 1 except that the filler was changed to the following filler: a filler ("KE-S30", produced by NIPPON SHOKUBAI Co., Ltd; an average particle seize: 0.24 µm; a maximum particle size: 0.9 µm) was used. The resin spacer film was exposed with an exposure amount of 700 mJ/cm². Thereafter, an elastic modulus of the exposed resin spacer film was measured at a temperature of 130°C. As a result, the elastic modulus of the exposed resin spacer film at the temperature of 130°C was 500 Pa or more as shown in the following Table 1.

### (Example 5)

A semiconductor device was manufactured in the same manner as in the Example 1 except that the amount of the filler was changed as follows, and therefore the amount of each component was changed as follows.
The amount of the above synthesized methacryl-modified bisphenol A novolac resin (MPN) as the alkali solubility resin (which is curing resin being curable by both light and heat) was 37.20 wt%, an amount of a phenol novolac resin ("PR53647", produced by SUMITOMO BAKELITE Co., Ltd) was 2.30 wt%, the amount of the acryl resin monomer having the liquid form at room temperature as the photopolymerization resin ("NKester 3G", produced by SHIN-NAKAMURA CHEMICAL CO.,LTD) was 9.20 wt%, the amount of the silica as the particulate filler ("NSS-3N", by produced TOKUYAMA Corp.; the average particle size: 0.125 µm; the maximum particle size: 0.35 µm) was 28.10 wt%, the amount of the bisphenol A novolac-type epoxy resin as the thermosetting resin ("EpiclonN-865", produced by DIC Corporation) was 18.60 wt%, the amount of the silicone epoxy resin ("BY16-115", produced by Dow Cornng Toray Co., Ltd) was 3.40 wt%, and the amount of the curing agent (photosensitizing agent) ("IRGACURE651", produced by Chiba Specialty Chemicals K.K) was 1.20 wt%. The resin spacer film was exposed with an exposure amount of 700 mJ/cm². Thereafter, an elastic modulus of the exposed resin spacer film was measured at a temperature of 130°C. As a result, the elastic modulus of the exposed resin spacer film at the temperature of 130°C was 500 Pa or more as shown in the following Table 1.

### (Example 6)

A semiconductor device was manufactured in the same manner as in the Example 2 except that the alkali solubility resin was changed to the following resin.
CyclomerP ACA200M (by produced by DAICEL CHEMICAL INDUSTRIES, LTD.; a propyleneglycol monomethylether solution having a solid component of 50 %) was used as the alkali solubility resin. The resin spacer film was exposed with an exposure amount of 700 mJ/cm². Thereafter, an elastic modulus of the exposed resin spacer film was measured at a temperature of 130°C. As a result, the elastic modulus of the exposed resin spacer film at the temperature of 130°C was 500 Pa or more as shown in the following Table 1.

### (Example 7)

A semiconductor device was manufactured in the same manner as in the Example 2 except that the amount of the filler was changed as follows, and therefore the amount of each component was changed as follows.
The amount of the above synthesized methacryl-modified bisphenol A novolac resin (MPN) as the alkali solubility resin (which is curing resin being curable by both light and heat) was 40.0 wt%, the amount of the acryl resin monomer having the liquid form at room temperature as the photopolymerization resin ("NKester 3G", produced by SHIN-NAKAMURA CHEMICAL CO.,LTD) was 12.5 wt%, the amount of the silica as the particulate filler ("NSS-3N", by produced TOKUYAMA Corp.; the average particle size: 0.125 µm; the maximum particle size: 0.35 µm) was 16.6 wt%, the amount of the bisphenol A novolac-type epoxy resin as the thermosetting resin ("EpiclonN-865", produced by DIC Corporation) was 24.9 wt%, the amount of the silicone epoxy resin ("BY16-115", produced by Dow Cornng Toray Co., Ltd) was 4.5 wt%, and the amount of the curing agent (photosensitizing agent) ("IRGACURE651", produced by Chiba Specialty Chemicals K.K) was 1.5 wt%. The resin spacer film was exposed with an exposure amount of 700 mJ/cm². Thereafter, an elastic modulus of the exposed resin spacer film was measured at a temperature of 130°C. As a result, the elastic modulus of the exposed resin spacer film at the temperature of 130°C was 500 Pa or more as shown in the following Table 1.

### (Example 8)

A semiconductor device was manufactured in the same manner as in the Example 2 except that the amount of the filler was changed as follows, and therefore the amount of each component was changed as follows.
The amount of the above synthesized methacryl-modified bisphenol A novolac resin (MPN) as the alkali solubility resin (curing resin be curable by both light and heat) was 42.3 wt%, the amount of the acryl resin monomer having the liquid form at room temperature as the photopolymerization resin ("NKester 3G", produced by SHIN-NAKAMURA CHEMICAL CO.,LTD) was 13.2 wt%, the amount of the silica as the particulate filler ("NSS-3N", by produced TOKUYAMA Corp.; the average particle size: 0.125 µm; the maximum particle seize: 0.35 µm) was 11.7 wt%, the amount of the bisphenol A novolac-type epoxy resin as the thermosetting resin ("EpiclonN-865", produced by DIC Corporation) was 26.4 wt%, the amount of the silicone epoxy resin ("BY16-115", produced by Dow Corning Toray Co., Ltd) was 4.8 wt%, and the amount of the curing agent (photosensitizing agent) ("IRGACURE651", produced by Chiba Specialty Chemicals K.K) was 1.6 wt%. The resin spacer film was exposed with an exposure amount of 700 mJ/cm². Thereafter, an elastic modulus of the exposed resin spacer film was measured at a temperature of 130°C. As a result, the elastic modulus of the exposed resin spacer film at the temperature of 130°C was 500 Pa or more as shown in the following Table 1.

### (Example 9)

A semiconductor device was manufactured in the same manner as in the Example 2 except that the amount of the filler was changed as follows, and therefore the amount of each component was changed as follows.
The amount of the above synthesized methacryl-modified bisphenol A novolac resin (MPN) as the alkali solubility resin (curing resin be curable by both light and heat) was 45.0 wt%, the amount of the acryl resin monomer having the liquid form at room temperature as the photopolymerization resin ("NKester 3G", produced by SHIN-NAKAMURA CHEMICAL CO.,LTD) was 14.0 wt%, the amount of the silica as the particulate filler ("NSS-3N", by produced TOKUYAMA Corp.; the average particle size: 0.125 µm; the maximum particle seize: 0.35 µm) was 6.2 wt%, the amount of the bisphenol A novolac-type epoxy resin as the thermosetting resin ("EpiclonN-865", produced by DIC Corporation) was 28.0 wt%, the amount of the silicone epoxy resin ("BY16-115", produced by Dow Corning Toray Co., Ltd) was 5.1 wt%, and the amount of the curing agent (photosensitizing agent) ("IRGACURE651", produced by Chiba Specialty Chemicals K.K) was 1.7 wt%. The resin spacer film was exposed with an exposure amount of 700 mJ/cm². Hereafter, an elastic modulus of the exposed resin spacer film was measured at a temperature of 130°C. As a result, the elastic modulus of the exposed resin spacer film at the temperature of 130°C was 500 Pa or more as shown in the following Table 1.

### (Comparative Example 1)

A semiconductor device was manufactured in the same manner as in the Example 1 except that the filler was changed to the following filler. A filler ("SO-E2", produced by Admatechs Company Limited; an average particle size: 0.5 µm; a maximum particle size: 2 µm) was used. The resin spacer film was exposed with an exposure amount of 700 mJ/cm². Thereafter, an elastic modulus of the exposed resin spacer film was measured at a temperature of 130°C. As a result, the elastic modulus of the exposed resin spacer film at the temperature of 130°C was 500 Pa or more as shown in the following Table 1.

### (Comparative Example 2)

A semiconductor device was manufactured in the same manner as in the Example 1 except that the filler was not used, and therefore the amount of each component was changed as follows.
The amount of the above synthesized methacryl-modified bisphenol A novolac resin (MPN) as the alkali solubility resin (curing resin be curable by both light and heat) was 59.90 wt%, the amount of the acryl resin monomer having the liquid form at room temperature as the photopolymerization resin ("NKester 3G", produced by SHIN-NAKAMURA CHEMICAL CO.,LTD) was 11.40 wt%, the amount of the bisphenol A novolac-type epoxy resin as the thermosetting resin ("EpiclonN-865", produced by DIC Corporation) was 23.00 wt%, the amount of the silicone epoxy resin ("BY16-115", produced by Dow Corning Toray Co., Ltd) was 4.20 wt%, and the amount of the curing agent (photosensitizing agent) ("IRGACURE651", produced by Chiba Specialty Chemicals K.K) was 1.50 wt%. The resin spacer film was exposed with an exposure amount of 700 mJ/cm². Thereafter, an elastic modulus of the exposed resin spacer film was measured at a temperature of 130°C. As a result, the elastic modulus of the exposed resin spacer film at the temperature of 130°C was less than 500 Pa as shown in the following Table 1.

In each of the resin spacer films and the semiconductor devices manufactured in the Examples 1 to 9 and the Comparative Examples 1 and 2, the following evaluation was carried out. A description will be made on the evaluation. The evaluated results are shown in Table 1.

### 1. Alignment Property

The resin spacer film was laminated on the semiconductor wafer at a temperature of 60°C with a rate of 0.3 m/min. By using an exposure device ("PLA-600FA", produced by Canon Inc.), a determination was made on as to whether or not a pattern formed on the surface of the semiconductor wafer was visible through the laminated resin spacer film to obtain a result. The result was evaluated according to four criteria. The four criteria are as follows.
A: Not only a pattern shape but also a boundary division between the pattern and the semiconductor wafer was clearly visible.
B: The pattern shape was visible, but the boundary division was slightly blurry.
C: The patter was slightly visible, but the patter shape was invisible.
D: The patter was absolutely invisible.

### 2. Developing Property

The resin spacer film was laminated on the semiconductor wafer at a temperature of 60°C with a rate of 0.3 m/min. A pattern mask having a reticular pattern was provided on (above) the resin spacer film. The pattern mask and the resin spacer film were exposed with the exposure amount of 700 mJ/cm² so that the resin spacer was formed in the reticular pattern. Thereafter, the pattern mask was removed, and then the exposed resin spacer film was developed by using 3% TMAH (a pressure of the liquid developer was 0.2 MPa; a developing time was 150 seconds) to obtain a grid pattern. The thus obtained grid pattern was observed by an electron microscope (×5,000 times). Then, a determination was made on as to whether or not residues are left on the grid pattern or the semiconductor wafer. The determination was evaluated according to two criteria. The two criteria are as follows.
B: The residues were not left.
D: The residues were left.
In this regard, it is to be noted that the pattern mask having a resin width of 1.2 mm and a grid gap of 5 mm was used.

### 3. Patterning Property

The resin spacer film was laminated on the semiconductor wafer at a temperature of 60°C with a rate of 0.3 m/min. A pattern mask having a reticular pattern was provided on (above) the resin spacer film. The pattern mask and the resin spacer film were exposed with the exposure amount of 700 mJ/cm² so that the resin spacer was formed in the reticular pattern. Thereafter, the pattern mask was removed, and then the exposed resin spacer film was developed by using 3% TMAH (a pressure of the liquid developer was 0.2 MPa; a developing time was 150 seconds) to obtain a grid pattern. The thus obtained grid pattern was visibly observed and evaluated according to three criteria. The three criteria are as follows.
B: The pattern was not peeled from the semiconductor wafer.
C: The pattern was partially peeled from the semiconductor wafer and a part of the pattern did not remain.
D: The pattern was totally peeled from the semiconductor wafer.
In this regard, it is to be noted that the pattern mask having a resin width of 1.2 mm and a grid gap of 5 mm was used.

### 4. Shape-keeping Property

By dicing a center portion of the resin spacer formed in the reticular pattern on the semiconductor wafer, to which the developing property was evaluated as described above, a semiconductor element having a resin spacer formed in a frame form was manufactured. When a glass substrate was heated and pressure-bonded on the resin spacer at a temperature of 120°C, flaws of the resin spacer were visibly observed to evaluate the shape-keeping property according to four criteria. The four criteria are as follows.
A: A dimension of the resin spacer was not changed even after heating and pressure-bonding of the glass substrate.
B: Some flaws were made to the resin spacer after heating and pressure-bonding of the glass substrate, and therefore the dimension of the resin spacer was not slightly changed. However, the shape of the resin spacer was not greatly changed.
C: The flaws were made to the resin spacer after heating and pressure-bonding of the glass substrate, and therefore the dimension of the resin spacer was changed.
D: A large number of the flaws were made to the resin spacer after heating and pressure-bonding of the glass substrate, and therefore both the dimension and the shape of the resin spacer was greatly changed.

Table 1

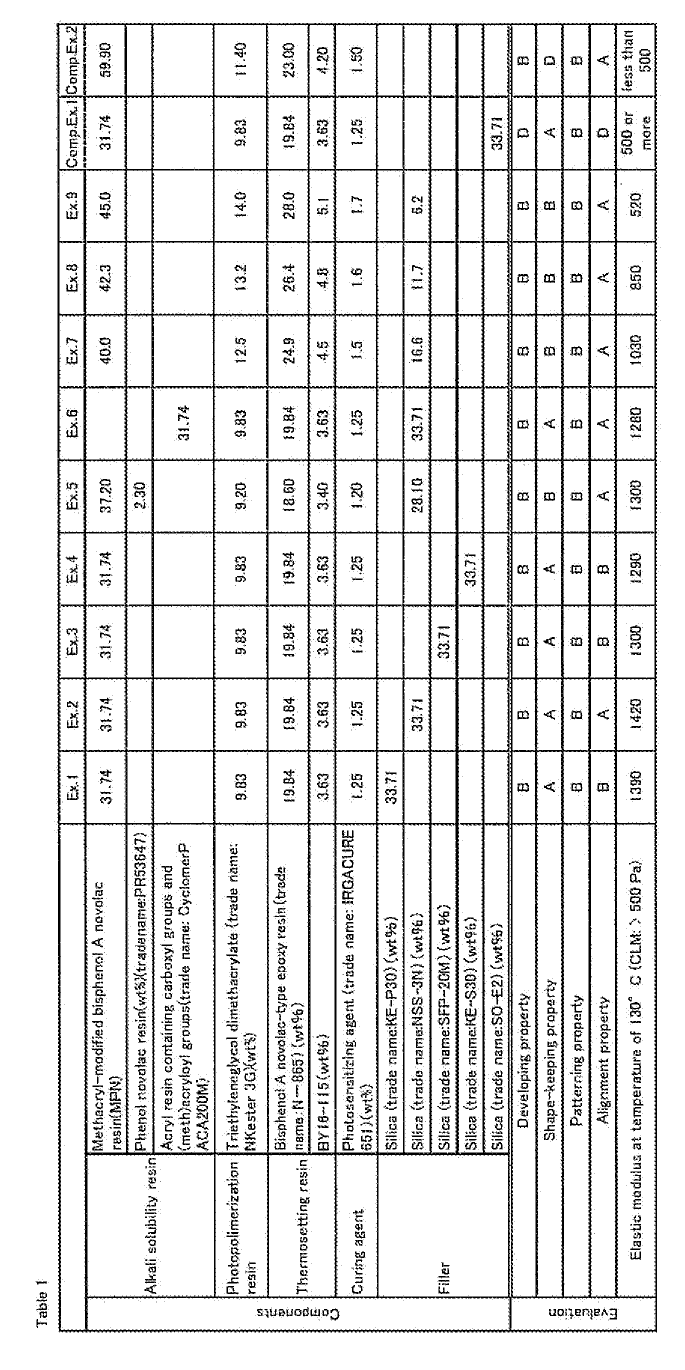

As seen from Table 1, in each of the semiconductor devices obtained in the Examples 1 to 9, it was possible to obtain excellent developing property of the resin spacer film, that is, reduce residues of the resin spacer film and the like. Further, it was also possible to obtain excellent shape-keeping property of the resin spacer. Furthermore, in each of the semiconductor devices obtained in the Examples 1 to 9, it was also possible to obtain patterning property of the resin spacer film. Additionally, in each of the semiconductor devices obtained in the Examples 2, 5 to 9, it was possible to obtain excellent alignment property of the pattern.

### INDUSTRIAL APPLICABILITY

According to the present invention, it is possible to provide a resin composition to be suitably used for forming a spacer used in such a semiconductor device as described above. Further, according to the present invention, it is possible to provide a resin spacer film formed of the resin composition, the resin spacer film having an excellent shape-keeping property as the spacer as well as an excellent developing property. Furthermore, according to the present invention, it is possible to provide a semiconductor device which includes an interposer on which a semiconductor element is mounted and a substrate bonded to the interposer or semiconductor element through a resin spacer constituted of a cured material of the resin composition described above.
Finally, it is also to be understood that the present disclosure relates to subject matters contained in Japanese Patent Applications No. 2007-148177 (filed on June 4, 2007) and No. 2007-139098 (filed on May 25, 2007) which are expressly incorporated herein by reference in their entireties.

## Claims

1. A resin composition to be used for a resin spacer provided in a semiconductor device, the semiconductor device comprising a substrate, a semiconductor element mounted on an interposer so as to face the substrate, and the resin spacer provided between the substrate and the interposer or the semiconductor element for bonding them together in a state that a space is formed between the substrate and the semiconductor element, wherein the resin composition comprising:
an alkali solubility resin;
a photopolimerization resin; and
a particulate filler;
wherein an average particle size of the particulate filler is in the range of 0.05 to 0.35 µm, and an amount of the particulate filler contained in the resin composition is in the range of 1 to 40 wt%,

2. The resin composition as claimed in claim 1,
wherein the particulate filler includes silica.

3. The resin composition as claimed in claim 1 further comprising a thermosetting resin being different from the alkali solubility resin.

4. A resin spacer film constituted of the resin composition defined in claim 1.

5. The resin spacer film as claimed in claim 4,
wherein the resin spacer film has an elastic modulus, and when the elastic modulus is measured under the following conditions, the elastic modulus of the resin spacer film is 500 Pa or more:
(1) a thickness of the resin spacer film is 100 µm;
(2) the resin spacer film which an ultraviolet ray of 700 (mJ/cm²) has exposed is used; and
(3) a measurement temperature is 130°C.

6. A semiconductor device comprising:
a substrate having one surface;
an interposer having one surface facing the one surface of the substrate;
a semiconductor element mounted on the one surface of the interposer; and
a resin spacer provided between the substrate and the interposer or the semiconductor element for bonding them together in a state that a space is formed between the substrate and the semiconductor element;
wherein the resin spacer is formed by curing the resin composition defined in claim 1.
